# EUROPÄISCHE PATENTSCHRIFT

(11) **EP 3 373 710 B1**
(45) Veröffentlichungstag und Bekanntmachung des Hinweises auf die Patenterteilung: **10.06.2020**
(21) Anmeldenummer: 18151177.5
(22) Anmeldetag: 11.01.2018
(51) Int. Cl.: H05K 1/02, H05K 3/28, H05K 3/00, G01S 7/481, H05K 5/06

(54) **VERFAHREN ZUR HERSTELLUNG EINES OPTOELEKTRONIKMODULS**
METHOD FOR MANUFACTURING AN OPTOELECTRONIC MODULE
PROCÉDÉ DE FABRICATION D'UN MODULE OPTOÉLECTRONIQUE

(30) Priorität: 08.03.2017 DE 102017104893
(43) Veröffentlichungstag der Anmeldung: 12.09.2018
(73) Patentinhaber: SICK AG, 79183 Waldkirch (DE)
(72) Erfinder: Döbele, Christian, 79341 Kenzingen (DE); Hörsch, Dr. Ingolf, 79102 Freiburg (DE)

(56) Entgegenhaltungen:
- EP-A1- 0 659 041
- EP-A1- 2 265 102
- WO-A1-2005/060100
- DE-A1-102005 008 885
- DE-U1-202013 004 379
- GB-A- 2 470 350
- US-A1- 2002 036 898
- US-A1- 2005 241 988
- US-A1- 2016 234 944

## Beschreibung

Die Erfindung betrifft ein Optoelektronikmodul, welches ein Gehäuse aufweist, das eine bestückte Leiterplatte vollständig umfasst, wobei auf der Leiterplatte Sendeelemente und Empfangselemente, Sende- und Empfangslinsen und/oder elektronische Bauteile zur Signalverarbeitung und/oder eine Kontaktierung für eine elektrische Leitung angeordnet sind sowie Verfahren zur Herstellung eines Optoelektronikmoduls nach dem Oberbegriff von Anspruch 1.

Die zunehmende Miniaturisierung von optoelektronischen Sensoren schreitet weiter voran, wobei elektronische und optoelektronische Bauelemente zunehmend verkleinert werden. Für bestimmte Applikationen ist neben der Längs- und Querausdehnung auch eine Höhe des Endmoduls entscheidend. Diese Elektronikmodule weisen dabei Kunststoffgehäuse auf, die vorwiegend über klassische Herstellverfahren, wie Spritzgussteile, welche z. B. mit Deckeln oder Frontscheiben durch Verkleben, Verspannen mit Dichtungen oder Ultraschallverschweißungen verbunden hergestellt werden. Alternativ werden funktionsfähige Optoelektronikmodule durch Spritzprozesse zu einer Umhausung umspritzt. Bei Kunststoffgehäusen stellt die Herstellung von flächigen Gehäusen mit gleichzeitig sehr dünnen Wandstärken eine hohe Herausforderung an den Spritzgussprozess. Die Mindestwandstärken sind bei einem solchen Spritzgussprozess herstellungsbedingt limitiert. Die Umspritztechnik erfordert ebenfalls Mindestwandstärken, die zu Material und Geometrie des Elektronikmoduls passen müssen.

Die WO 2005/060100 A1 offenbart eine Steuer- und Benutzerschnittstelle für eine elektronische Vorrichtung, umfassend eine Basismembranstruktur zum Bilden einer oder mehrerer Folientasten und Leitungsverbindungen und eine Oberflächenmembran zum Schützen der Basismembranstruktur und zum Verwenden der Tasten, wobei ein im IR-Bereich arbeitender Sender-Empfänger mit der Basismembranstruktur integriert ist und die Oberflächenmembran dafür ein für IR-Licht transparenter Teil im Betriebsbereich des Sender-Empfängers aufweist. Der Sender-Empfänger ist vorteilhafterweise ein IrDA-Sender-Empfänger.

Die DE 20 2013 004 379 U1 offenbart ein Endoskop mit einer an einem distalen Ende ausgebildeten Endoskopspitze, mindestens einer in der Endoskopspitze angeordneten Abbildungsoptik und mindestens einem in der Endoskopspitze hinter der mindestens einen Abbildungsoptik angeordneten Bildaufnahmesensor, wobei die mindestens eine Abbildungsoptik an mindestens einer tragenden Struktur gehalten ist, wobei in der Endoskopspitze eine Metallfolie angeordnet ist, welche mit der mindestens einen tragenden Struktur dicht verbunden ist und welche einen den mindestens einen Bildaufnahmesensor aufnehmenden Innenraum dicht abschließt.

Die US 2016/0234944 A1 offenbart verschiedene Sensoren und Verfahren zum Zusammenbau von Sensoren. In einigen Ausführungsformen beinhaltet die Sensoranordnung ein erstes Ende, einen Körperabschnitt und ein zweites Ende. Das erste Ende kann einen Halsabschnitt und einen Verbindungsabschnitt beinhalten und das zweite Ende kann eine Klappe, eine erste Komponente, einen Halsabschnitt und eine zweite Komponente beinhalten. Ein Verfahren wird auch für die Sensorfaltung beschrieben. Das Verfahren kann die Verwendung einer Schaltung mit einem angeschlossenen Emitter und einem Detektor beinhalten, der durch einen Teil der Schaltung getrennt ist. Das Verfahren kann auch das Falten des Abschnitts der Schaltung beinhalten, so dass eine erste Falte durch den Emitter erzeugt wird, und das Falten des Abschnitts der Schaltung, so dass eine zweite Falte erzeugt wird, so dass die erste Falte und die zweite Falte einen Winkel bilden.

Der Erfindung liegt die Aufgabe zugrunde, ein Elektronikmodul anzugeben, welches ein flächiges Gehäuse aufweist, das nur minimal zur Gesamtdicke des Elektronikmoduls beiträgt, aber trotzdem das Optoelektronikmodul zuverlässig vor Umwelteinflüssen wie Wasserdampf, Chemikalien bzw. EMV schützt.

Die Aufgabe wird durch ein Verfahren zur Herstellung eines Optoelektronikmoduls gemäß Anspurch 1 gelöst.

Erfindungsgemäß ist mindestens ein Teil des Gehäuses von einer reißfesten, stabilen Folie gebildet welche dicht an der bestückten Leiterplatte anschließt. Solche Folien können beliebig dünn ausgestaltet werden, weshalb sie nur einen geringen Beitrag zur Gesamtdicke des Optoelektronikmoduls leisten. Da sie aber die innenliegende Elektronik des Optoelektronikmoduls zuverlässig abdichten, ist ein umfassender Schutz gegen Umwelteinflüsse wie Wasserdampf-, Chemie-, EMV-Einflüsse und ähnliches gegeben. Die Verwendung von Folien für das flächige Gehäuse erlaubt die Herstellung von sogenannten Miniatur-Flatsensoren.

Das Optoelektronikmodul bildet einen Sensor bzw. kann synonym als Sensor bezeichnet werden. Der Sensor ist ein optoelektronischer Sensor. Beispielsweise handelt es sich bei dem Sensor um eine Lichtschranke, einen Lichttaster, einen Distanzsensor oder einen ähnlichen Sensor. Der Sensor weist einen Schaltausgang zur Ausgabe eines Schaltsignales auf. Der Schaltausgang wird über die elektrische Leitung beispielsweise mit einer Steuerung verbunden. Die Folie bildet ein optisches Fenster des Sensors. Damit ist die Folie auch Teil des optischen Sende- und Empfangspfades.

Vorteilhafterweise besteht die Folie aus Kunststoff, Teflon (Polytetrafluorethylen) oder Metall, vorzugsweise Edelmetall. Somit können je nach Verwendungszweck des Optoelektronikmoduls die entsprechenden Folienarten ausgewählt werden, um die beschriebenen Aufgaben am Einsatzort zuverlässig zu erfüllen. Die geringe Dicke der Folien ermöglicht in jedem Fall einen minimalen Gehäuseaufbau.

In einer Ausgestaltung des durch das erfindungsgemäße Verfahren hergestellten Optoelektronikmoduls ist das gesamte Gehäuse aus zwei Folien gebildet, die mittels Thermoumformen der Geometrie bzw. Topologie der bestückten Leiterplatte angepasst sind. Die beiden Folien werden über eine Klebe- oder Schweißverbindung dicht miteinander verbunden.

In einer Alternative des durch das erfindungsgemäße Verfahren hergestellten Optoelektronikmoduls ist das gesamte Gehäuse von einer gefalteten Folie gebildet, wobei die bestückte Leiterplatte von der gefalteten Folie umgeben ist, die mittels Thermoumformen der Geometrie bzw. Topologie der bestückten Leiterplatte angepasst ist. Auch hier werden die Ränder der gefalteten Folien nach dem Einschluss der bestückten Leiterplatte dicht über Klebe- oder Schweißverbindungen miteinander verbunden.

In einer illustrativen, nicht zur Erfindung gehörigen Variante ist das Gehäuse aus einer Frontabdeckung aus gespritztem Kunststoff gebildet, welches mit einer rückseitig auf die Frontabdeckung aufgebrachten Folie stoffschlüssig abgedichtet ist. Eine solche Frontabdeckung kann gleichzeitig zur Aufnahme optischer Elemente, wie beispielsweise Linsen benutzt werden, wobei die Leiterplatte bloß noch einen Elektronikkern aufweist.

Alternativ besteht das Gehäuse aus zwei Folien, zwischen welchen ein Abstandsrahmen angeordnet ist, an welchem die beiden Folien den Abstandsrahmen abdeckend befestigt sind. Der Vorteil des Abstandsrahmens liegt in der ebenen Front und Rückfläche des Sensors.

Um eine gegebenenfalls zu schwache Folienstruktur zu verstärken, umfasst das Gehäuse ein Versteifungselement.

In einer Ausführungsform besteht das Gehäuse aus einer Metallfolie, wobei zwischen der Metallfolie und der bestückten Leiterplatte ein Isoliereinlegeelement angeordnet ist. Die Verwendung von Metallfolien ist insbesondere immer dann angebracht, wenn die mechanische Robustheit des Optoelektronikmoduls, z.B. hinsichtlich von Verwindungssteifigkeit, erhöht werden soll.

In einer illustrativen, nicht zur Erfindung gehörigen Variante besteht das Gehäuse aus einer rückseitigen, gegenüber der Leiterplatte isolierten Metallfolie, mit welcher eine aus einer Kunststoffabdeckung bestehende Frontseite verbunden ist. Somit lassen sich auch je nach gewünschtem Einsatzfall und Anwendung des Optoelektronikmoduls gemischte Gehäuse, die sowohl aus Folien als auch aus Kunststoff bestehen, einsetzen.

In einer illustrativen, nicht zur Erfindung gehörigen Ausführungsform ist die rückwärtige Metallfolie zur Aufnahme der Kunststoffabdeckung aufgekantet. Dies hat den Vorteil, dass die Robustheit des Optoelektronikmoduls gesteigert wird.

Um Dichtungsanforderungen an einen Metallfolienverbund zu reduzieren, weist das aus mindestens einer Kunststofffolie bestehende Gehäuse eine Ummantelung aus einer Metallfolie auf.

Vorteilhafterweise ist die elektrische Leitung übergangslos von dem Gehäuse umgeben. Dadurch werden Dichtstellen eliminiert, so dass auch gleichzeitig mit dem Gehäuse die elektrische Leitung zuverlässig gegen Umwelteinflüsse abgedichtet ist.

In einer illustrativen, nicht zur Erfindung gehörigen Variante ist das Gehäuse durch einen Folienschlauch, vorteilhafterweise einen Schrumpfschlauch, gebildet. Bei einem solchen Schrumpfschlauch ist die Herstellung der Einzelmodule sehr einfach, da die bestückte Trägerplatte nur in den Schlauch eingeschoben werden muss, welcher durch Hitzeeinbringung schrumpft und die bestückte Leiterplatte umschließt.

Beim erfindungsgemäßen Verfahren zur Herstellung eines Optoelektronikmoduls werden optoelektronische Bauelemente und elektronische Bauteile zur Signalverarbeitung und/oder eine Kontaktierung elektrisch verbunden auf einem Trägerelement angeordnet Bei dem Verfahren, welches für die Massenproduktion geeignet ist, werden mehrere als Leiterplatten ausgebildete Trägerelemente auf einer Folie zueinander beabstandet verteilt aufgebracht und die Trägerelemente von derselben oder einer zweiten Folie abgedeckt, wobei alle Folienränder der gefalteten Folie oder der ersten und der zweiten Folie gleichzeitig stoffschlüssig miteinander verbunden werden und die Optoelektronikmodule anschließend vereinzelt werden.

Eine weitere Weiterbildung der Erfindung betrifft ein Verfahren zur Herstellung eines Optoelektronikmoduls, bei welchem mehrere Leiterplatten beabstandet zueinander auf einer Rückfolie angeordnet werden, anschließend eine Bestückung der Leiterplatten mit optoelektronischen Bauelementen erfolgt, der eine Linsenbestückung nachfolgt und danach jede bestückte Leiterplatte mit einer Anschlussleitung versehen wird, wobei die mit der Anschlussleitung versehenen Leiterplatten mit einer Deckfolie abgedeckt werden, welche nach dem Auflegen mit einer Rückfolie stoffschlüssig verbunden wird und aus diesem Verbund die Optoelektronikmodule vereinzelt werden. Auch eine solche Vorgehensweise ermöglicht eine Massenproduktion, um eine hohe Stückzahl dieser miniaturisierten Optoelektronikmodule herzustellen.

Die Erfindung lässt zahlreiche Ausführungsformen zu. Mehrere davon sollen anhand der in der Zeichnung dargestellten Figuren näher erläutert werden.

Es zeigen:
Fig. 1 ein erstes Ausführungsbeispiel des Optoelektronikmoduls,
Fig. 2 ein weiteres Ausführungsbeispiel des Optoelektronikmoduls,
Fig. 3 ein weiteres , illustratives, nicht zur Erfindung gehöriges Ausführungsbeispiel des Optoelektronikmoduls,
Fig. 4 ein weiteres Ausführungsbeispiel des Optoelektronikmoduls,
Fig. 5 ein weiteres Ausführungsbeispiel des Optoelektronikmoduls,
Fig. 6 ein weiteres Ausführungsbeispiel des Optoelektronikmoduls,
Fig. 7 ein weiteres Ausführungsbeispiel des Optoelektronikmoduls,
Fig. 8 ein weiteres Ausführungsbeispiel des Optoelektronikmoduls,
Fig. 9 ein weiteres, illustratives, nicht zur Erfindung gehöriges Ausführungsbeispiel des Optoelektronikmoduls, illustratives, nicht zur Erfindung gehöriges
Fig. 10 ein weiteres Ausführungsbeispiel des Optoelektronikmoduls,
Fig. 11 ein weiteres Ausführungsbeispiel des Optoelektronikmoduls,
Fig. 12 ein weiteres, illustratives, nicht zur Erfindung gehöriges Ausführungsbeispiel des Optoelektronikmoduls,
Fig. 13 ein weiteres Ausführungsbeispiel des Optoelektronikmoduls,
Fig. 14 ein weiteres Ausführungsbeispiel des Optoelektronikmoduls,
Fig. 15 ein weiteres Ausführungsbeispiel des Optoelektronikmoduls,
Fig. 16 ein weiteres Ausführungsbeispiel des Optoelektronikmoduls,
Fig. 17 ein weiteres Ausführungsbeispiel des Optoelektronikmoduls,
Fig. 18 ein weiteres Ausführungsbeispiel des Optoelektronikmoduls,
Fig. 19 ein weiteres Ausführungsbeispiel des Optoelektronikmoduls,
Fig. 20 ein weiteres Ausführungsbeispiel des Optoelektronikmoduls,
Fig. 21 ein weiteres Ausführungsbeispiel des Optoelektronikmoduls,
Fig. 22 ein weiteres Ausführungsbeispiel des Optoelektronikmoduls,
Fig. 23 ein Ausführungsbeispiel der Herstellung eines erfindungsgemäßen Optoelektronikmoduls,
Fig. 24 ein Ausführungsbeispiel für die Ausprägung eines Lichtgitters und eines Lichtarrays.

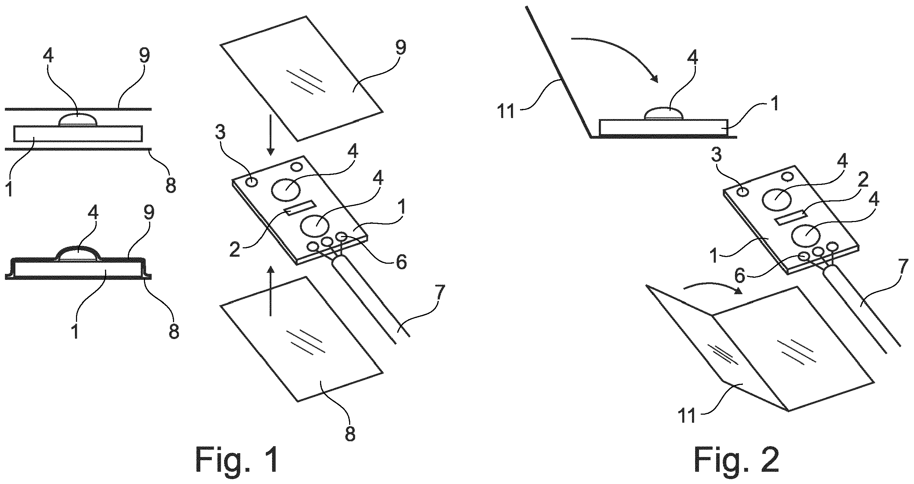

In Fig. 1 ist ein erstes Ausführungsbeispiel eines Optoelektronikmoduls dargestellt, welches eine Leiterplatte 1 umfasst, auf welcher ein Sendeelement und ein Empfangselement angeordnet sind, vor denen Linsen 4 angeordnet sind. Weiterhin befinden sich auf der Leiterplatte 1 Bauteile zur Signalverarbeitung, Anzeigeelemente 3, wie auch Anschlusskontakte 6 zum Anschluss einer elektrischen Leitung 7. Diese bestückte Leiterplatte 1 ist beidseitig von einer Rückfolie 8 und einer Frontfolie 9 abgedeckt (Fig. 1a), wobei die Folien 8 und 9 die Leiterplatte 1 überragen und die Ränder 10 der Folien 8, 9 dicht über Klebe- oder Schweißverbindungen miteinander verbunden werden. Die Folien 8, 9 werden optional über einen Thermoumformer an die Geometrie bzw. Topologie der bestückten Leiterplatte angepasst, wie es in Fig. 1c dargestellt ist.

In Fig. 2 wird anstelle von zwei Folien nur eine gefaltete Folie 11 verwendet, wobei auf die eine Seite der gefalteten Folie 11 die bestückte Leiterplatte 1 aufgelegt wird, während die zweite Hälfte der gefalteten Folie 11 über die bestückte Leiterplatte 1 geklappt wird. Auch hier werden im Fall der Verwendung von Kunststofffolien mittels Thermoumformen die Folienenden der gefalteten Folie 11 an die Struktur des Optoelektronikmoduls angepasst.

Die Ränder der gefalteten Folie 11 bzw. der beiden Folien 8, 9 werden mittels Klebe- und Schweißverbindungen miteinander verbunden. Die geringe Dicke der Folien 8, 9, 11 ermöglicht einen minimalen Gehäuseaufbau, wobei die optischen Bauteile, wie beispielsweise Linsen, direkt durch die Folien 9, 11 niedergehalten werden können.

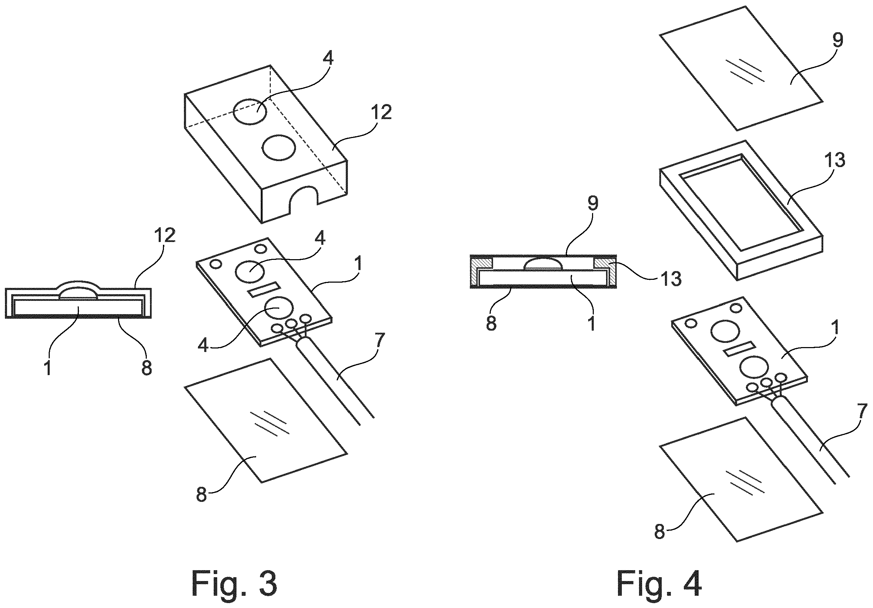

In Fig. 3 ist ein weiteres, illustratives, nicht zur Erfindung gehöriges Ausführungsbeispiel des Optoelektronikmoduls dargestellt, bei welchem die bestückte Leiterplatte 1 auf eine rückseitige Kunststofffolie 8 aufgesetzt wird. Die Abdeckung auf der den elektronischen Bauteilen zugewandten Seite erfolgt durch eine gespritzte, aus Kunststoff bestehender Frontabdeckung 12, welche gegebenenfalls Optogeometrien, wie beispielsweise Linsen 4, beinhalten kann.

In einem weiteren Ausführungsbeispiel des Optoelektronikmoduls ist die bestückte Leiterplatte 1 auf die rückwärtige Kunststofffolie 8 aufgelegt. Die Leiterplatte 1 wird von einem Abstandsrahmen 13 umgeben, welcher ebenfalls auf der rückwärtigen Folie 8 aufsitzt, wobei der Abstandsrahmen 13 von der Frontfolie 9 abgedeckt wird. Der Abstandsrahmen 13 wird dabei von beiden Seiten jeweils mit einer Folie 8, 9 abgedeckt (Fig. 4).

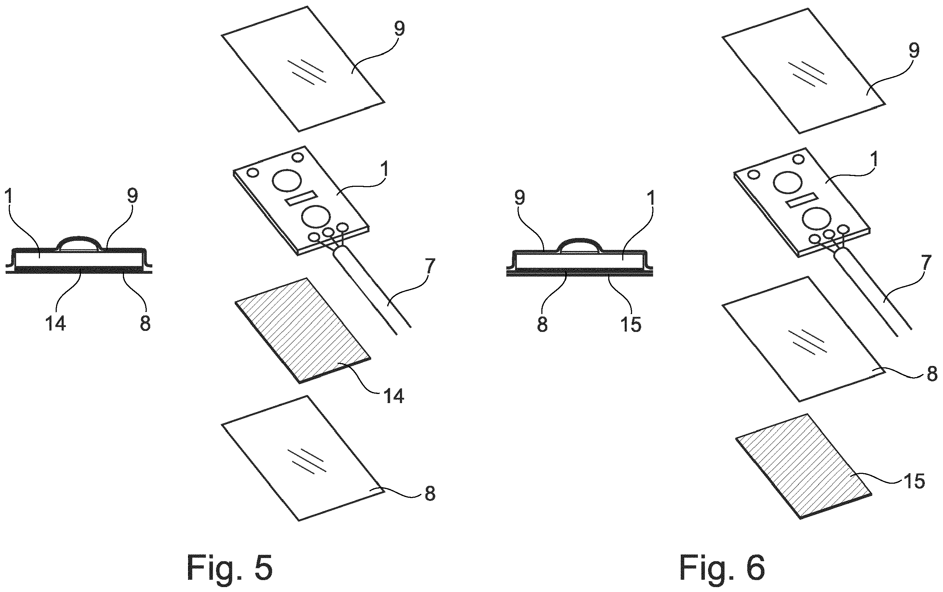

Um gegebenenfalls zu schwache Folienstrukturen zu verstärken, wird eine Versteifung durch geeignete Materialien, wie beispielsweise einem Stahlblech, eingeführt. Fig. 5 zeigt ein weiteres Ausführungsbeispiel mit einer inneren Verstärkung, wobei ein dünnes Stahlblech 14 vor dem Verschweißen der Folien 8, 9 unter die bestückte Leiterplatte 1 gelegt wird. Allerdings muss hierbei beachtet werden, dass die Isolation des Stahlbleches 14 zur Leiterplatte 1 vorhanden bleibt und EMV-Einflüsse unterbunden werden.

In einer Alternative ist eine äußere Verstärkung möglich, wobei das Verstärkungselement in Form des Stahlbleches 15 außen an eine der Folien 8, 9, vorzugsweise die rückwärtige Folie 8, angebracht wird. Dabei kann das Stahlblech 15 an die äußere rückwärtige Folie 8 geklebt oder formschlüssig arretiert werden (Fig. 6).

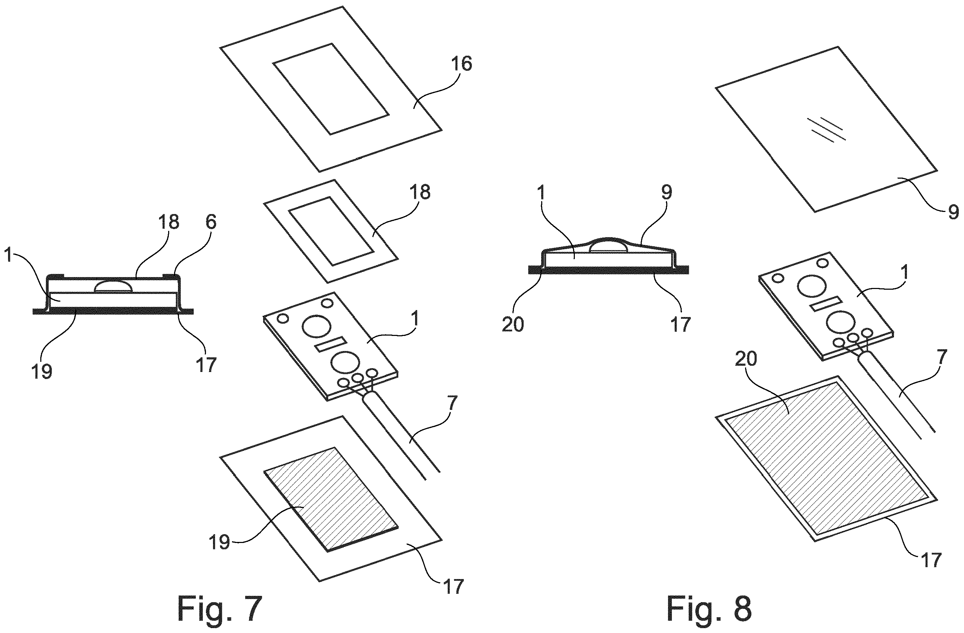

Um die mechanische Robustheit sowie das visuelle Erscheinungsbild wertiger zu gestalten, ist neben Kunststoff auch ein Einsatz von Metall- oder Edelstahlfolien denkbar. Gemäß Fig. 7 ist ein eigenständiges Gehäuse aus zwei Edelstahlfolien 16, 17 gebildet. Nach Einlegen der Leiterplatte 1 werden die Edelstahlfolien 16, 17 umlaufend durch Verkleben oder Verschweißung abgedichtet. Die Frontfolie 16 kann dabei eine Frontscheibe 18 aufweisen, die durch Klebstoff in die Frontfolie 16 integriert ist. Alternativ ist die Frontfolie 16 als Frontscheibenfolie ausgebildet. Um hohe Isoliereigenschaften in dem Metallgehäuse, welches durch die Edelstahlfolien 16, 17 gebildet wird, zu gewährleisten, ist die Leiterplatte 1 durch Klebung oder ein Isoliereinlegeteil 19 in Form eines dünnen Kunststoffplättchens gegen die rückseitige Folie 17 getrennt.

In Fig. 8 ist ein weiteres Ausführungsbeispiel für die Verwendung von Edelstahl- und Kunststofffolien in einem gemischten Verbund dargestellt. Die rückseitige Folie 17 wird dabei durch eine Metallfolie gebildet, während die Frontfolie 9 eine Kunststofffolie darstellt. Der Dichtverbund erfolgt durch Verklebung der Metall- und der Kunststofffolie 17, 9. Auch in diesem Fall ist die bestückte Leiterplatte 1 durch eine Isolierplatte 20 aus Kunststoff oder einen Klebstoff vollständig von der rückseitigen Metallfolie 17 getrennt.

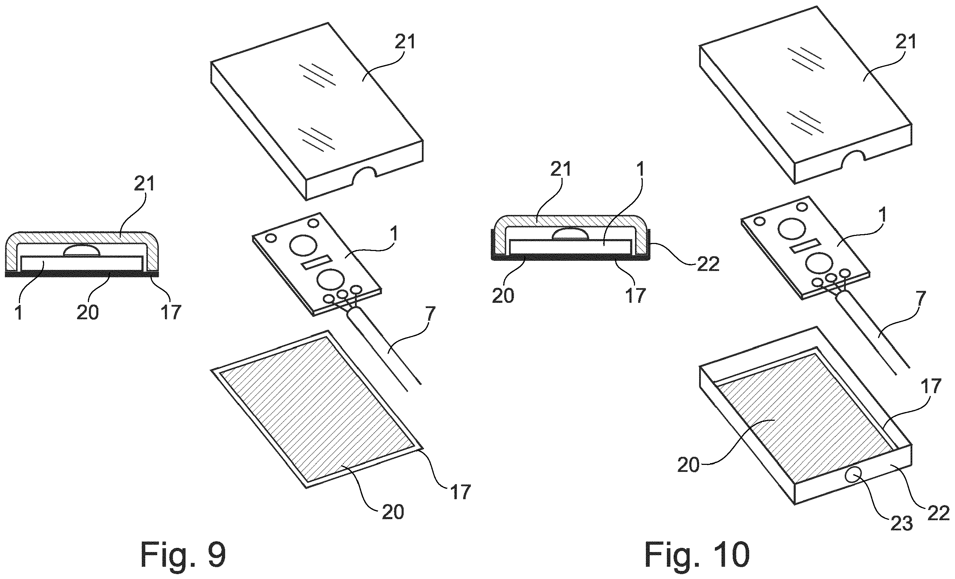

Gemäß Fig. 9 wird eine fragile, als Abdeckung dienende Kunststofffolie 9 durch ein gespritztes Frontelement 21 aus Kunststoff ersetzt, was insbesondere dazu beiträgt, dass bei mechanischen Belastungen das Optoelektronikmodul nicht beschädigt wird. Auch dieses gespritzte Frontelement 21 wird mit der aus Metall bestehenden rückseitigen Folie 17 abdichtend verbunden. Das Frontelement kann auch die Linsen 4 bereits enthalten, um den Anforderungen an einen möglichst flachen Aufbau gerecht zu werden.

Um die Robustheit des Optoelektronikmoduls zu erhöhen, wird an der rückseitigen Metallfolie 17 eine Aufkantung 22 aus der Metallfolie 17 ausgeführt. Anschließend wird die bestückte Leiterplatte 1 in diese Schale eingelegt, wobei die Leitung 7 durch eine Öffnung 23 der Aufkantung 22 an die Umgebung ausgeführt wird. Das gespritzte Frontelement 21 aus Kunststoff wird dann in die aufgekantete rückseitige Metallfolie 17 eingesetzt (Fig. 10).

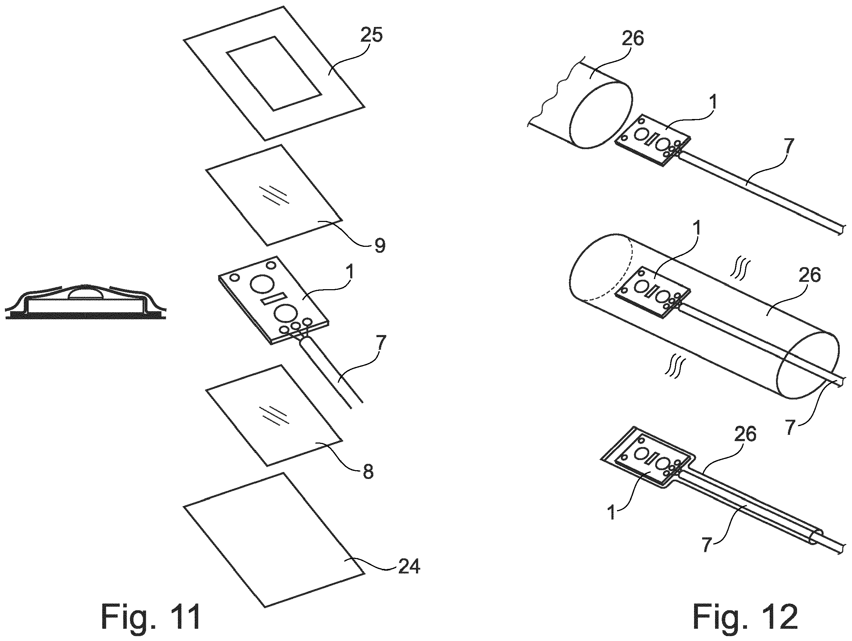

In Fig. 11 ist ein weiteres Ausführungsbeispiel des Optoelektronikmoduls gezeigt, bei welchem die nach Fig. 2 mit zwei Kunststofffolien 8 oder 9 umgebene bestückte Leiterplatte 1 mit zwei Metallfolien 24, 25 ummantelt wird. Hierbei bestehen keine Dichtanforderungen an den durch die beiden Metallfolien 24, 25 gebildeten Folienverbund. Es ist lediglich eine mechanische Fixierung zum Kunststoffgehäuse, wie beispielsweise durch Verkleben oder Formschluss, notwendig.

In einem weiteren, illustrativen, nicht zur Erfindung gehörigen Ausführungsbeispiel, wie es in Fig. 12 dargestellt ist, ist als optionale Alternative zur Folienummantelung eine Ummantelung durch einen sogenannten Schrumpfschlauch möglich. Hierbei wird die bestückte Leiterplatte 1 samt Leitung 7 in den Folienschlauch 26 eingeschoben. Durch die Einbringung von Hitze zieht sich der gestreckte Folienschlauch 26 zusammen und umschließt die bestückte Leiterplatte 1. Die Abdeckung von bestückter Leiterplatte 1 und Leitung 7 erfolgt dabei durch diese Ummantelung übergangslos. An einer, zur Leitung 7 entgegengesetzt liegenden Seite wird nach der Umhüllung der bestückten Leiterplatte 1 das Optoelektronikmodul einseitig durch thermische Einflüsse verschweißt oder verklebt.

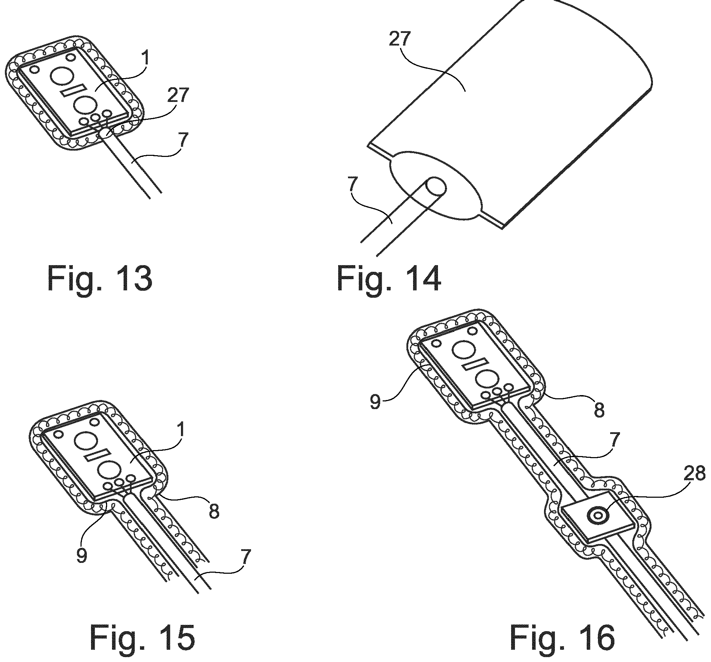

Das Optoelektronikmodul wird, wie bereits schon ausgeführt, mittels einer elektrischen Leitung 7 mit der Umgebung verbunden. Als Anschlusstechnik können dabei Rundleitungen, Flachbandleitungen oder gedruckte oder auflaminierte Leitungsstrukturen, die direkt auf der Folie 8 oder 9 aufgebracht sind, verwendet werden. Bei der direkten Ausführung der Anschlussleitung 7 aus dem durch die Folien 8, 9 gebildeten Gehäuse ist eine Abdichtung zwischen Foliengehäuse und Leitung 7 erforderlich. Je nach Werkstoffkombination erfolgt die Abdichtung der Schnittstelle 27, Leitungsmantel zur Folie, durch ein direktes dichtes Verschweißen des Leitungsaderwerkstoffes mit der Folie (bei Kunststoff) oder durch einen Klebstoff bei Metallfolien (Fig. 13). Eine elliptische Anbindung der Schnittstelle 27 ist in Fig. 14 dargestellt. Hierbei kann die Schweißung oder Klebung direkt auf die passenden Leitungsmaterialien oder durch einen passenden Zwischenkörper, welche eine optimale Anbindung an die Leitung und/oder die Folie bereitstellt erfolgen. Ein nicht abgebildetes Zwischenteil könnte beispielsweise als ringförmiges Element, beispielsweise innen rund für Leitung und außen elliptisch für Folie noch ergänzt werden.

Die elektrische Leitung 7 kann aber auch wie in Fig. 15 gezeigt, zusammen mit der bestückten Leiterplatte 1 durch die rückseitige Folie 8 und die Frontfolie 9 abgedeckt werden, so dass das durch die rückseitige Folien 8 und der Frontfolie 9 gebildete Gehäuse übergangslos auf die Leitung 7 übergeht, weshalb auf eine zusätzliche Abdichtung verzichtet werden kann.

Ergänzend zur beschriebenen Integration der Leitung 7 als fester Bestandteil des Gehäuses kann auch ein Bedienelement 28, beispielsweise in Form eines Tasters, als Zwischenelement in die elektrische Leitung 7 integriert werden, welches dann ebenfalls übergangslos in dem Folienverbund, welcher die elektrische Leiterplatte 1 und die elektrische Leitung 7 umgibt, mit eingebracht wird (Fig. 16).

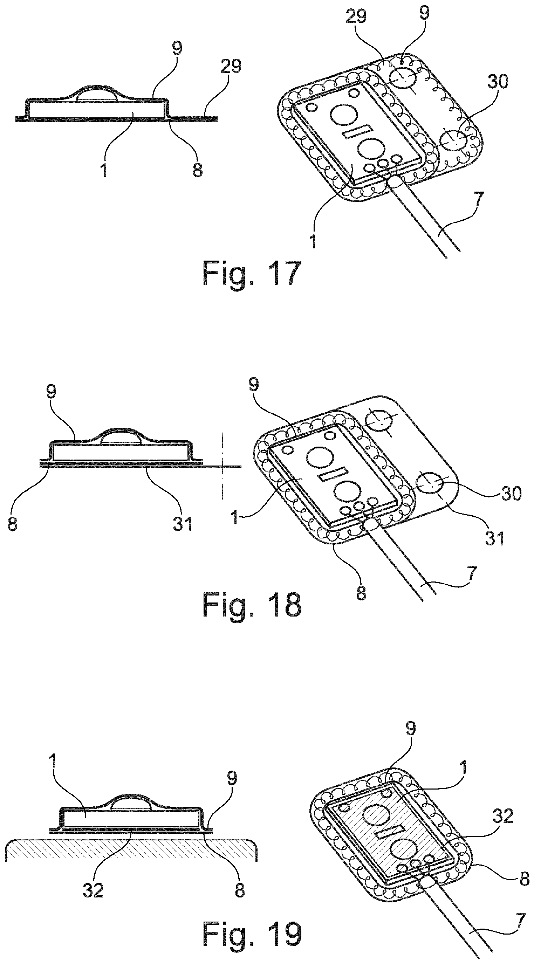

Eine Montage eines mit einem Foliengehäuse umschlossenen eigenständigen Optoelektronikmoduls kann auf verschiedene Weise erfolgen. Dabei überragt die zur Abdeckung der elektrischen Leiterplatte 1 verwendete Folie die Leiterplatte 1, wie in Fig. 17 dargestellt. In diesen überragenden Teil 29 der Folie 8 können Öffnungen oder Löcher 30 eingebracht werden, in welche nicht weiter dargestellte Bolzen oder Schrauben eingeführt werden und mit denen das eigenständige Optoelektronikmodul an dem entsprechenden Ort befestigt werden kann.

In Fig. 18 ist ein weiteres Ausführungsbeispiel dargestellt, bei welchem das eigenständige Optoelektronikmodul auf einer flexibel ausgeführten Montageplatte 31 angeordnet ist, welche ebenfalls das Optoelektronikmodul überragt und entsprechende Öffnungen 30 zur Befestigung am Verwendungsort aufweist. Die Montageplatte 31 kann mit dem Foliengehäuse verklebt oder formschlüssig verbunden sein. Wie aus Fig. 19 hervorgeht, kann die Montageplatte aber auch im Folienverbund angeordnet sein, wobei die Montageplatte als Magnetplatte 32 ausgebildet ist, so dass auf mechanische Befestigungselemente zur Anbringung des eigenständig ausgebildeten Optoelektronikmoduls verzichtet werden kann.

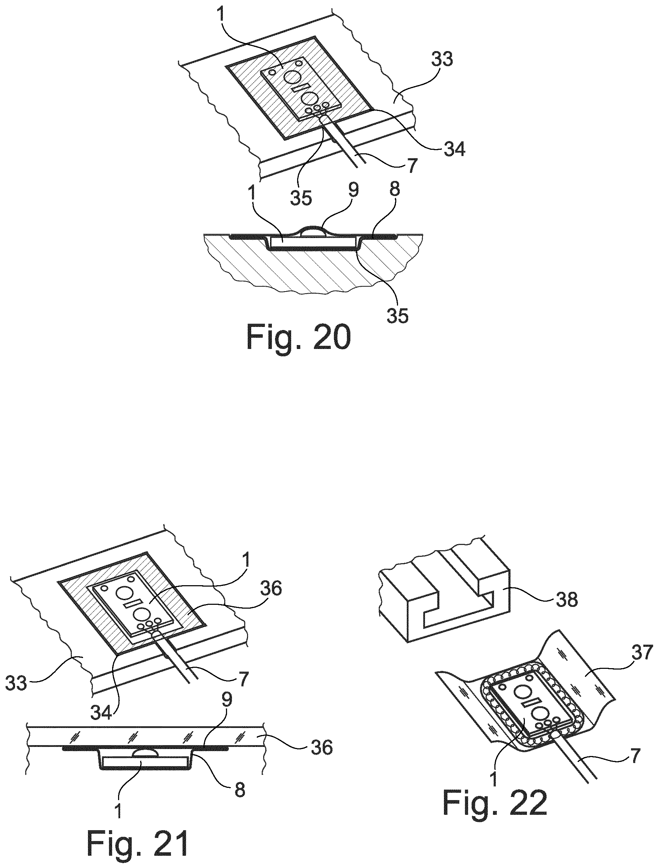

Wie aus den Fig. 20 und 21 hervorgeht, besteht die Möglichkeit, das Optoelektronikmodul mit den Folien auf vorgesehene Flächen 33 aufzukleben oder in dafür vorgesehene Taschen 34 in der Applikation einzusetzen. Das Aufkleben, wie es in Fig. 20 dargestellt ist, erfolgt durch einen separaten Klebstoff 35 oder durch eine an dem Optoelektronikmodul befestigte selbstklebende Folie. Das Optoelektronikmodul wird so in die Applikation eingesetzt, dass es mit seiner Oberfläche die Applikation abschließt. In einer weiteren Ausführung, wie sie in Fig. 21 dargestellt ist, wird das Optoelektronikmodul in der Applikation versenkt und mittels einer Abdeckfolie 36 abgedeckt, so dass eine ebene Oberfläche entsteht. Durch die Verwendung der Folien lassen sich auch elastische Strukturen an dem Optoelektronikmodul herstellen, welche form- oder kraft- oder reibschlüssig auf die gewünschte Anwendung abgestimmt werden. So lassen sich beispielsweise, wie in Fig. 22 gezeigt, Federelemente 37, welche durch thermisches Umformen der Folien direkt am Gehäuse erzeugt werden, herstellen, die mit einem Schwalbenschwanzprofil 38 zur Applikation harmonieren, wodurch das Optoelektronikmodul 39 nach Einführung des Federelementes 37 in das Schwalbenschwanzprofil 38 am Verwendungsort befestigt ist.

Erfindungsgemäß wird unter Verwendung von Kunststoff-, Teflon- oder Metallfolien ein Batch-Herstellungsprozess realisiert, bei welcher eine Vielzahl von Optoelektronikmodulen 39 auf einer Folie angeordnet wird. Anschließend wird eine zweite Folie auf die Optoelektronikmodule 39 aufgelegt. Die Verbindung der Folien in Form von Kleben oder Schweißen wird parallel durchgeführt. Nachfolgend werden die so verkapselten Optoelektronikmodule 39 via Stanz- oder Schneidevorgängen vereinzelt.

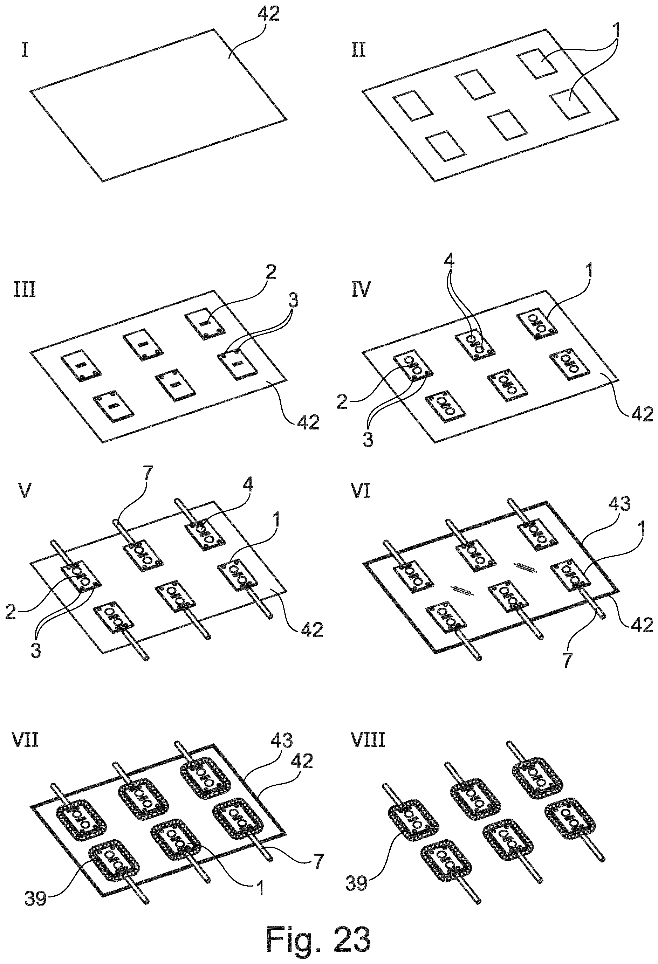

Alternativ zu einem bereits fertigen Optoelektronikmodul 39 kann der Aufbau des Optoelektronikmoduls 39 in den Gehäuseaufbauprozess integriert werden. Dies ist in Fig. 23 dargestellt. Hierbei werden auf eine Trägerfolie 42, beispielsweise eine Metallfolie, im Schritt I mehrere bestückte Leiterplatten 1 beabstandet aufgebracht (Schritt II). Im Schritt III erfolgt dann eine Bestückung der Leiterplatten 1 mit optoelektronischen Bauteilen 2. Im Schritt IV erfolgt die Bestückung mit Linsen 4 auf jeder Leiterplatte 1. Anschließend wird im Schritt V an jede Leiterplatte 1 eine Anschlussleitung 7 angefügt. Nach dem Anfügen der Anschlussleitung 7 an die jeweilige Leiterplatte 1 werden alle Leiterplatten 1 mit einer einzigen Deckfolie 43, die beispielsweise aus Kunststoff besteht, abgedeckt (Schritt VI). Eine Verklebung bzw. Verschweißung der Deckfolie 43 mit der Rückfolie 42 erfolgt im Schritt VII. Anschließend werden im Schritt VIII die Optoelektronikmodule 39 aus dem Verbund vereinzelt.

Als Folienmaterialien werden vorwiegend thermoplastische Materialien bevorzugt. Hinsichtlich chemischer Beständigkeit sind Teflon-Folien optimal, welche ebenfalls miteinander verschmelzt werden können. An die Folien ist neben den beschriebenen Eigenschaften die Anforderung der optischen Transparenz für die Deckfolie von besonderer Bedeutung. Außerdem sollen die Folien diffusionsdichte Eigenschaften haben. Die Folien können aber auch farbig ausgebildet werden, um Aufgaben der Spektralfilterung zu unterstützen.

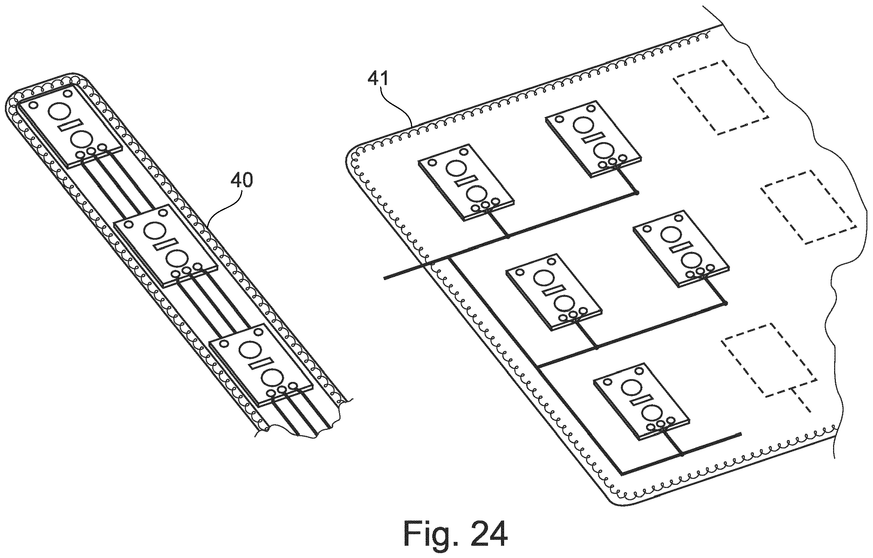

Neben der Nutzung des Verfahrens zur Ummantelung einzelner Optoelektronikmodule wäre auch der Einsatz für aneinanderhängende Sensoren denkbar, die Funktionen ähnlich eines Lichtgitters 40 bereitstellen können. Weiterführend ist auch eine mehrdimensionale Ausführung als Array-Sensor 41 denkbar, wie er in Fig. 24 dargestellt ist.

Die beschriebenen Lösungen haben die Vorteile der Bereitstellung maximal flacher, wirtschaftlich herstellbarer und im Falle von Teflon-Folien sogar chemisch hochbeständiger Sensorgehäuse. Die Batch-Verarbeitung mehrerer Sensoren senkt dabei die Fertigungskosten.

### Bezugszeichen

- 1: Leiterplatte
- 2: elektronische Bauteile
- 3: Anzeigeelement
- 4: Linse
- 6: Anschlusskontakt
- 7: Leitung
- 8: Rückseitige Folie
- 9: Frontfolie
- 10: Rand der Folie
- 11: gefaltete Folie
- 12: gespritzte Frontabdeckung
- 13: Abstandrahmen
- 14: Stahlblech
- 15: Stahlblech
- 16: Edelstahlfolie
- 17: Edelstahlfolie
- 18: Frontscheibe
- 19: Isoliereinlegeteil
- 20: Isolierplatte
- 21: gespritztes Frontelement
- 22: Aufkantung
- 23: Öffnung
- 24: Metallfolie
- 25: Metallfolie
- 26: Folienschlauch
- 27: Schnittstelle: Leitungsmantel - Folie
- 28: Bedienelement
- 29: überragendes Teil der Folie
- 30: Loch
- 31: Montageplatte
- 32: Magnetplatte
- 33: Applikationsfläche
- 34: Ausnehmung
- 35: Klebstoff
- 36: Abdeckfolie
- 37: Federelement
- 38: Schwalbenschwanzprofil
- 39: Optoelektronikmodul
- 40: Lichtgitter
- 41: Array-Sensor
- 42: Trägerfolie
- 43: Deckfolie

## Patentansprüche

1. Verfahren zur Herstellung eines Optoelektronikmoduls, wobei das Optoelektronikmodul einen Sensor bildet, welcher ein Gehäuse (8, 9; 11; 16, 17; 24, 25) aufweist, das eine bestückte Leiterplatte (1) vollständig umfasst, wobei auf der Leiterplatte (1) Sendeelemente und Empfangselemente, Sende- und Empfangslinsen (4) und elektronische Bauteile (2) zur Signalverarbeitung und eine Kontaktierung (6) für eine elektrische Leitung (7) angeordnet sind, wobei mindestens ein Teil des Gehäuses von einer reißfesten, stabilen Folie (8, 9; 11; 16, 17; 24, 25) gebildet ist, welche dicht an die bestückte Leiterplatte (1) anschließt, wobei, der Sensor einen Schaltausgang zur Ausgabe eines Schaltsignals aufweist, wobei der Schaltausgang über eine elektrische Leitung mit einer Steuerung verbunden ist, wobei bei dem Verfahren optoelektronische Bauelemente und elektronische Bauteile (6) zur Signalverarbeitung und eine Kontaktierung elektrisch verbunden auf einem Trägerelement (1) angeordnet werden, **dadurch gekennzeichnet, dass** mehrere als Leiterplatten (1) ausgebildete Trägerelemente zueinander beabstandet auf einer Folie (8, 9) verteilt aufgebracht werden und die Trägerelemente von derselben (8, 9) oder einer zweiten Folie (8, 9) abgedeckt werden, wobei alle Folienränder (10) der gefalteten Folie (11) oder der ersten und der zweiten Folie (8, 9) gleichzeitig stoffschlüssig miteinander verbunden werden und die Optoelektronikmodule (39) nach der Verbindung vereinzelt werden.

2. Verfahren zur Herstellung eines Optoelektronikmoduls, nach Anspruch 1, **dadurch gekennzeichnet, dass** die mehrere Leiterplatten (1) beabstandet zueinander auf der als Rückfolie (8) ausgeführten Folie angeordnet werden, anschließend eine Bestückung der Leiterplatten (1) mit optoelektronischen Bauelementen erfolgt, der eine Bestückung mit Linsen (4) nachfolgt und danach jede bestückte Leiterplatte (1) mit einer Anschlussleitung (7) versehen wird, wobei die mit den Anschlussleitungen (7) versehenen Leiterplatten (1) mit der als Deckfolie (43) ausgeführten zweiten Folie abgedeckt werden, welche nach dem Auflegen mit der Rückfolie (8) stoffschlüssig verbunden wird und aus diesem Verbund die Optoelektronikmodule (39) vereinzelt werden.

3. Verfahren zur Herstellung eines Optoelektronikmoduls nach Anspruch 1, **dadurch gekennzeichnet, dass** die Folie (8, 9; 24, 25) aus Kunststoff oder Teflon oder Metall, vorzugsweise Edelmetall, besteht.

4. Verfahren zur Herstellung eines Optoelektronikmoduls nach Anspruch 1, **dadurch gekennzeichnet, dass** das Gehäuse aus zwei Folien (8, 9) gebildet ist, die mittels Thermoumformen der Geometrie bzw. Topologie der bestückten Leiterplatte (1) angepasst ist.

5. Verfahren zur Herstellung eines Optoelektronikmoduls nach Anspruch 1, **dadurch gekennzeichnet, dass** das gesamte Gehäuse aus einer gefalteten Folie (11) besteht, wobei die bestückte Leiterplatte (1) von der gefalteten Folie (11) umgeben ist, die mittels Thermoumformen der Geometrie bzw. Topologie der bestückten Leiterplatte angepasst ist.

6. Verfahren zur Herstellung eines Optoelektronikmoduls nach mindestens einem der vorhergehenden Ansprüche 1 bis 4, **dadurch gekennzeichnet, dass** das Gehäuse aus zwei Folien (8, 9) besteht, zwischen welchen ein Abstandsrahmen (13) angeordnet ist, an welchem die beiden Folien (8, 9), diesen Abstandsrahmen (13) abdeckend, befestigt sind.

7. Verfahren zur Herstellung eines Optoelektronikmoduls nach mindestens einem der vorhergehenden Ansprüche, **dadurch gekennzeichnet, dass** das Gehäuse (8, 9) ein Versteifungselement (14, 15) umfasst.

8. Verfahren zur Herstellung eines Optoelektronikmoduls nach Anspruch 1, **dadurch gekennzeichnet, dass** das Gehäuse (16,17) aus einer Metallfolie (17) besteht, wobei zwischen der Metallfolie (17) und der bestückten Leiterplatte (1) ein Isoliereinlegeelement (19, 20) angeordnet ist.

9. Verfahren zur Herstellung eines Optoelektronikmoduls nach mindestens einem der vorhergehenden Ansprüche, **dadurch gekennzeichnet, dass** das aus mindestens einer Kunststofffolie bestehende Gehäuse eine Ummantelung (24, 25) aus einer Metallfolie (24, 25) aufweist.

10. Verfahren zur Herstellung eines Optoelektronikmoduls nach mindestens einem der vorhergehenden Ansprüche, **dadurch gekennzeichnet, dass** die elektrische Leitung (7) übergangslos von dem Gehäuse (8, 9; 11; 16, 17; 24, 25) umgeben ist.

## Claims

1. A method of manufacturing an optoelectronic module, wherein the optoelectronic module forms a sensor that has a housing (8, 9; 11; 16, 17; 24, 25) that completely encompasses a mounted circuit board (1); wherein transmission elements and reception elements, transmission and reception lenses (4), and electronic components (2) for signal processing and contacting (6) for an electric lead (7) are arranged on the circuit board (1); wherein at least a part of the housing is formed from a tear-proof, stable film (8, 9; 11; 16, 17; 24, 25) that sealingly adjoins the mounted circuit board (1); wherein the sensor has a switching output for outputting a switching signal; wherein the switching output is connected to a control via an electric lead; and wherein in said method, optoelectronic component parts and electronic components (6) for signal processing and contacting are arranged electrically connected on a carrier element (1), **characterized in that** a plurality of carrier elements configured as circuit boards (1) are applied distributed spaced apart from one another on a film (8, 9); and **in that** the carrier elements are covered thereby (8, 9) or by a second film (8, 9), with all the film margins (10) of the folded film (11) or of the first and second films (8, 9) simultaneously being connected to one another with material continuity and the optoelectronic modules (39) being separated after the connection.

2. A method of manufacturing an optoelectronic module in accordance with claim 1, **characterized in that** the plurality of circuit boards (1) are arranged spaced apart from one another on the film designed as a rear film (8); **in that** a mounting of the circuit boards (1) with optoelectronic component parts subsequently takes place that is followed by a mounting with lenses (4), and then every mounted circuit board (1) is provided with a connecting lead (7), with the circuit boards (1) provided with the connecting leads (7) being covered by the second film that is designed as a top film (8) that is connected to the rear film (8) with material continuity after the placing on, and with the optoelectronic modules (39) being separated from this composite.

3. A method of manufacturing an optoelectronic module in accordance with claim 1, **characterized in that** the film (8, 9; 24, 25) comprises plastic or Teflon or metal, preferably precious metal.

4. A method of manufacturing an optoelectronic module in accordance with claim 1, **characterized in that** the housing is formed from two films (8, 9) that are matched to the geometry or topology of the mounted circuit board (1) by means of thermoforming.

5. A method of manufacturing an optoelectronic module in accordance with claim 1, **characterized in that** the total housing comprises a folded film (11), with the mounted circuit board (1) being surrounded by the folded film (11) that is matched to the geometry or topology of the mounted circuit board by means of thermoforming.

6. A method of manufacturing an optoelectronic module in accordance with at least one of the preceding claims 1 to 4, **characterized in that** the housing comprises two films (8, 9) between which a spacer frame (13) is arranged to which the two films (8, 9) are fastened while covering said spacer frame (13).

7. A method of manufacturing an optoelectronic module in accordance with at least one of the preceding claims, **characterized in that** the housing (8, 9) comprises a stiffening element (14, 15).

8. A method of manufacturing an optoelectronic module in accordance with claim 1, **characterized in that** the housing (16, 17) comprises a metal film (17), with an insulating insert (19, 20) being arranged between the metal film (17) and the mounted circuit board (1).

9. A method of manufacturing an optoelectronic module in accordance with at least one of the preceding claims, **characterized in that** the housing comprising at least one plastic film has a sheath (24, 25) composed of a metal film (24, 25).

10. A method of manufacturing an optoelectronic module in accordance with at least one of the preceding claims, **characterized in that** the electric lead (8) is seamlessly surrounded by the housing (8, 9; 11; 16, 17; 24, 25).

## Revendications

1. Procédé de réalisation d'un module optoélectronique, le module optoélectronique constituant un capteur qui comprend un boîtier (8, 9 ; 11 ; 16 ; 17 ; 24, 25) qui entoure complètement une carte à circuit équipée (1), dans lequel des éléments émetteurs et des éléments récepteurs, des lentilles d'émission et de réception (4) et des composants électroniques (2) pour le traitement des signaux et un contact (6) pour une ligne électrique (7) sont disposés sur la carte à circuit (1), une partie au moins du boîtier est formée par une feuille solide (8, 9 ; 11 ; 16, 17 ; 24, 25) résistante à la déchirure qui se raccorde de manière étanche à la carte à circuit équipée (1), le capteur présente une sortie de commutation pour émettre un signal de commutation, la sortie de commutation est connectée à une commande par l'intermédiaire d'une ligne électrique, procédé dans lequel des composants optoélectroniques et des composants électroniques (6) pour le traitement des signaux et un contact sont disposés sur un élément porteur (1) en étant connectés électriquement, **caractérisé en ce que** plusieurs éléments porteurs réalisés sous forme de cartes à circuit (1) sont montés sur une feuille (8, 9) en étant repartis à distance les uns des autres, et les éléments porteurs sont recouverts par la même feuille (8, 9) ou par une seconde feuille (8, 9), tous les bords (10) de la feuille pliée (11) ou de la première et de la seconde feuille (8, 9) sont reliés simultanément par coopération de matière les uns aux autres, et une fois reliés, les modules optoélectroniques (39) sont individualisés.

2. Procédé de réalisation d'un module optoélectronique selon la revendication 1, **caractérisé en ce que** lesdites plusieurs cartes à circuit (1) sont disposées à distance les unes des autres sur la feuille conçue comme feuille arrière (8), puis les cartes à circuit (1) sont équipées de composants optoélectroniques, puis elles sont équipées de lentilles (4) et ensuite chaque carte à circuit équipée (1) est pourvue d'une ligne de connexion (7), les cartes à circuit (1) pourvues des lignes de connexion (7) étant recouvertes de la seconde feuille conçue comme feuille de couverture (43) qui, une fois posée, est reliée par coopération de matière à la feuille arrière (8), et c'est à partir de cet ensemble assemblé que les modules optoélectroniques (39) sont individualisés.

3. Procédé de réalisation d'un module optoélectronique selon la revendication 1, **caractérisé en ce que** la feuille (8, 9 ; 24, 25) est constituée en matière plastique ou en téflon ou en métal, de préférence en métal précieux.

4. Procédé de réalisation d'un module optoélectronique selon la revendication 1, **caractérisé en ce que** le boîtier est formé de deux feuilles (8, 9) qui sont adaptées par thermoformage à la géométrie ou à la topologie de la carte à circuit équipée (1).

5. Procédé de réalisation d'un module optoélectronique selon la revendication 1, **caractérisé en ce que** l'ensemble du boîtier est constitué d'une feuille pliée (11), la carte à circuit équipée (1) étant entourée de la feuille pliée (11) qui est adaptée par thermoformage à la géométrie ou à la topologie de la carte à circuit équipée.

6. Procédé de réalisation d'un module optoélectronique selon l'une au moins des revendications précédentes 1 à 4, **caractérisé en ce que** le boîtier est constitué de deux feuilles (8, 9) entre lesquelles est disposé un cadre d'écartement (13) auquel sont fixées les deux feuilles (8, 9) en recouvrant ledit cadre d'écartement (13).

7. Procédé de réalisation d'un module optoélectronique selon l'une au moins des revendications précédentes, **caractérisé en ce que** le boîtier (8, 9) comprend un élément de rigidification (14, 15).

8. Procédé de réalisation d'un module optoélectronique selon la revendication 1, **caractérisé en ce que** le boîtier (16, 17) est constitué d'une feuille métallique (17), un élément d'insertion isolant (19, 20) étant disposé entre la feuille métallique (17) et la carte à circuit équipée (1).

9. Procédé de réalisation d'un module optoélectronique selon l'une au moins des revendications précédentes, **caractérisé en ce que** le boîtier constitué d'au moins une feuille en matière plastique comprend une enveloppe (24, 25) en une feuille métallique (24, 25).

10. Procédé de réalisation d'un module optoélectronique selon l'une au moins des revendications précédentes, **caractérisé en ce que** la ligne électrique (7) est entourée sans discontinuité par le boîtier (8, 9 ; 11 ; 16, 17 ; 24, 25).
